# EUROPEAN PATENT APPLICATION

(11) **EP 1 237 270 A2**
(43) Date of publication of application: **04.09.2002**
(21) Application number: 02010727.2
(22) Date of filing: 25.08.1998
(51) Int. Cl.: H02M 5/297

(54) **Controlled diode recovery circuit**

(30) Priority: 05.02.1998 FI 980259
(62) Divisional of application: 98202840.9
(71) Applicant: Helvar Oy Ab, 00380 Helsinki (FI)
(72) Inventor: Wade, Scott, West Kingsdown, Sevenoaks, Kent TN15 6EJ (GB)
(74) Representative: LEITZINGER OY

(57) **Abstract**

The invention relates to a controlled diode recovery circuit which is used with two semiconductor switches having anti-parallel diodes (either intrinsic to the switching device, or electrically connected to the switch), the circuit including a saturable inductor (L1) in series with the switching semiconductors. In parallel with a series combination of the saturable inductor and each semiconductor switch/diode, there is a series combination of a second inductor (L2) and a second diode (D2). The second inductor (L2) is dimensioned for a controlled rate of increase in reverse recovery current of the diode (Dm1/Dm2) to be recovered. The second diode (D2) has its forward direction opposite to the forward direction of the diode (Dm1/Dm2) to be recovered, while allowing the flow of the reverse recovery current of the diode (Dm1/Dm2) to be recovered.

## Description

The invention relates to a *controlled diode recovery circuit* (C.D.R. circuit) which is used with two semiconductor switches having anti-parallel diodes (either intrinsic to the switching device, or electrically connected to the switch), the circuit including a saturable inductor in series with the switching semiconductors.

This circuit controls the reverse recovery current of diodes or of semiconductor switch body diodes. When a diode is reverse biased after carrying forward current, it takes some time to recover its blocking ability, while carriers recombine. This circuit will control the reverse current flowing during this time so that the recovering diode and the rest of the circuit are protected from large stresses which would otherwise be caused by huge reverse recovery current flowing.

A method commonly used to control diode recovery current is to control (lower) the speed of the associated switching device. This method gives high losses in the switching device due to it carrying diode recovery current and output current (usually to an inductor) while in the linear region. The switching device will be in the linear region while the diode is recovering.

A second method is to use a saturable (square loop) inductor in series with the diode. This inductor blocks the reverse current flow, without controlling its rate of increase, and greatly increases the recovery time of the diode. This method also has the problem of blocking forward current flow in the time it takes the inductor to saturate for current flow in that direction. A larger V.t (volt-time) rating of saturable inductor will be required than with the C.D.R. circuit according to the present invention, as this prior known circuit does not provide a controlled rate of reverse current flow (needed to recover the diode quickly).

There are other circuits used to limit the reverse recovery characteristics of diodes. Some of these are for specific types of converter, whereas the C.D.R. circuit according to the present invention is simply connected in series with the main diodes or semiconductor switch body diodes, allowing use in a wide variety of circuits, such as an AC chopper (line frequency power converter).

The a.c. chopper method varies the r.m.s. voltage while maintaining the input waveform frequency and shape.

The a.c. chopper solves the problem with phase cutting controllers of line frequency harmonics and rise times, at the expense of higher cost and reduced efficiency. The novelties presented here help reduce the cost and increase efficiency of the a.c. chopper, though are not limited in use to this type of circuit.

The C.D.R. circuit according to the present invention is designed to allow a controlled rate of increase in reverse recovery current so that the diode recovers quickly. The optimum rate of increase in reverse current for the application can be chosen. This also means the peak reverse current is also limited due to the rate of increase in reverse current and the speed of the diode.

To obtain these characteristics and the desired control of the reverse recovery current, the invention is characterized by the features of claim 1. Dependent claims define advantageous application configurations wherein the circuit according to this invention can be used.

When the diode to be recovered is required to conduct in a forward direction, the C.D.R. circuit presents little impedance to current flow. This is because the circuit automatically provides a V.t across the saturable inductor, for forward conduction, after recovery of the diode to be recovered.

The novel controlled diode recovery circuit according to the present invention, when applied in the a.c. chopper, further reduces switching losses and device stresses, making the overall power conversion more efficient and reliable. This allows higher switching frequencies, smaller and lower rated components to be used, and higher efficiency, with significant cost savings.

A further advantage of the C.D.R. circuit is that it allows the body diode of high speed switching semiconductors to be used at high switching frequencies, while giving low losses and low device stresses.

In other words, the C.D.R. circuit presented here is a novel way to control the slope of the reverse recovery current of a diode, without having to control the turn on speed of the associated power switch, and also presenting minimum impedance or delay when the diode is required to conduct in the forward direction.

A preferred embodiment of the invention is characterized in that in parallel with the second inductor, there is a series connection of a third diode and an impedance, the third diode and the main diode having the same forward direction.

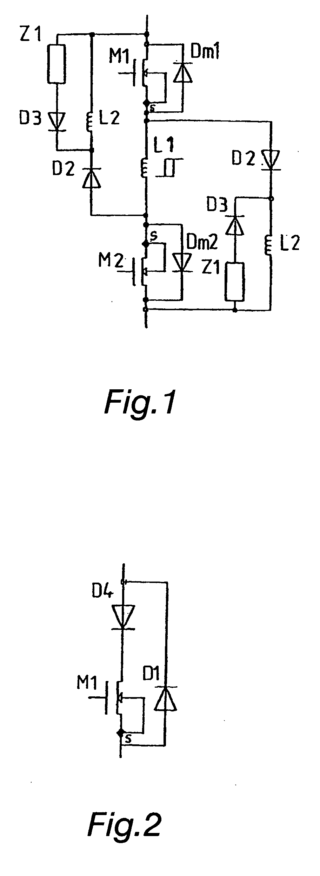

In this embodiment energy recovery is possible by making use of the energy transferred from the second inductor L2 to the impedance Z1 after recovery (see figure 1). Alternatively, this energy may be dissipated in Z1.

The C.D.R. circuit may be used with two switches, connected in anti-series, allowing use with an a.c. supply (such as Fig. 1).

Different circuit configurations of the invention will now be described in more detail with reference to the enclosed drawing, wherein
- Figure 1: shows the C.D.R. recovery circuits with A.C. chopper circuit configuration; and
- Figure 2: shows an alternative switch which can be used in the circuit configuration of Figure 1, the switch being provided with series schottky diode and antiparallel freewheel diode.

The controlled diode recovery (C.D.R.) circuit is shown in **figure 1** This circuit allows the corresponding power switch (such as switches M1-M2 in Fig. 1) to be turned on rapidly, without regard for the main diode (Dm1 or Dm2) recovery current slope or magnitude. The circuit connected to M1, M2, Dm1, Dm2, has the function of controlling the reverse recovery current of Dm1 and Dm2, while giving low power loss, and unhindered forward conduction of Dm1 and Dm2. L1 is a saturable inductor.

The circuit of figure 1 is symmetrical. Operation will be described for forward current flow through Dm1. However, the description applies symmetrically to the case when forward flow is instead through Dm2. References to D2, D3, L2 or Z1 in the following, apply to the recovery circuit for Dm1, which is shown on the right of figure 1, connected across L1 and M2.

During forward conduction of Dm1, all the current flows through L1. L1 is saturated, and no current flows through the D2 or D3 branches. Losses are mainly due to the forward conduction losses of M2 and Dm1.

When Dm1 is reverse biased, it will not block reverse current flow until it recovers. No current will flow through the D3 branch, as it recovers almost immediately, due to no forward current previously flowing through D3. L1, which was previously carrying current from bottom to top, will block the voltage now across it until its volt-second rating is exceeded. Therefore, the only branch which will support reverse recovery current of Dm1 is presently the L2/D2 branch. The current flow starts at zero and increases approximately linearly due to the voltage across L2.

Eventually Dm1 recovers, with the peak recovery current flowing through L2/D2, and the volt-second rating of L1 not quite reached. The peak recovery current will now freewheel through the L2/Z1/D3 loop, decaying as the energy is dissipated in resistance of Z1. A voltage appears across Z1 due to this current, causing L1's bottom terminal to be positive with respect to its top. This moves the state of L1 towards saturation for current flow from bottom to top. The volt-second (v.t) product required to reduce the L2 current to zero is the same as that required to saturate L1 for current flow in the main diode forward direction. Possibilities for Z1 include a single resistor, a resistor in series with a parallel R-C, or an energy recovery circuit. The second possibility allows fast reduction of the L2 current (and saturating of L1) while giving a smaller peak voltage drop in comparison to a single resistor.

When Dm1 is next required to conduct, L1 will rapidly saturate (if not already saturated) during the fall time of the top rail voltage. D3 recovers during the time that Dm1 is carrying forward current flow.

It can be seen that the C.D.R. circuit adds no significant conduction losses, and reduces switching losses due to the controlled reverse recovery current of the main diode.

The circuit is symmetrical, so operation is identical when the voltage polarity across the rails is reversed, and the current flow is in the opposite direction (Dm2 carrying forward current), the symmetrically placed components being used instead of those described above.

The saturable inductor, L1, has some finite inductance even when saturated. This means some energy is stored when current is flowing, causing a voltage spike across the switch being turned off. Provided the saturated inductance is small enough, the energy stored here will (usefully) charge the output capacitance of the switch being turned off.

Due to an imperfect hysteresis loop, L1 will allow some reverse current flow through Dm1, though this will be limited. This current adds to the controlled current slope, and will increase recovery speed but gives larger peak recovery current.

There are other circuit configurations which are covered by the same inventive concept. Such configurations are:
i) when the semiconductor switches used in arrangements described already, are used with a series connected diode D4 (usually a schottky) and an antiparallel diode D1 for reverse conduction, connected across both the switch and the series diode (**figure 2).**
ii) when the switch source and drain (or collector/emitter) connections are reversed, and all diode anode/cathodes are reversed in the previously described circuits.
iii) If the forward voltage (Vf) of the C.D.R. diodes (D2 & D2 of figure 1) are lower than the Vf of the body diodes (Dm1 & Dm2), then two impedances (e.g. resistors or extra diodes) may be required in series with D2 or L2, to increase the effective Vf, preventing steady state current flow through D2/L2 of left branch instead of L1/Dm1, or D2/L2 of right branch instead of L1/Dm2.

## Claims

1. Controlled diode recovery circuit which is used with a series combination of two semiconductor switches (M1, M2) which have opposite forward directions, with an antiparallel diode (Dm1, Dm2, D1) either intrinsic to each semiconductor switch or electrically connected to each semiconductor switch, the circuit including a saturable inductor (L1) connected in series between the switches, **characterised in that** the antiparallel diode (Dm1, Dm2, D1) of each semiconductor switch (M1, M2) has a recovery circuit (D2, L2) connected in parallel with the series combination of the saturable inductor (L1) and the other (M2, M1) of the semiconductor switches, the recovery circuit including a series combination of an inductor (L2) and a first diode (D2) having its forward direction opposite to the forward direction of the antiparallel diode it controls the recovery of (Dm1, Dm2, D1), the inductor of the recovery circuit (L2) being dimensioned for controlled rate of increase in reverse recovery current of said antiparallel diode (Dm1, Dm2, D1).

2. Circuit according to claim 1, **characterised in that** the recovery circuit includes a series combination of a further diode (D3) and an impedance (Z1) connected in parallel with the inductance (L2) of the recovery circuit, the further diode (D3) having its forward direction opposite to the forward direction of the first diode (D2) of the recovery circuit.

3. Circuit according to claim 1 or claim 2, **characterised in that** the antiparallel diode (Dm1, Dm2) is a body diode (Dm1, Dm2) of the semiconductor switch (M1, M2).

4. Circuit according to claim 1 or claim 2, **characterised in that** the antiparallel diode (Dm1, Dm2) is a freewheel diode (D1) connected in parallel with a series combination of the semiconductor switch (M1, M2) and a schottky diode (D4).
